# EUROPEAN PATENT APPLICATION

(11) **EP 4 485 135 A1**
(43) Date of publication of application: **01.01.2025**
(21) Application number: 23215208.2
(22) Date of filing: 08.12.2023
(51) Int. Cl.: G06F 1/20, G06F 1/16

(54) **THERMAL MANAGEMENT SYSTEMS FOR ELECTRONIC DEVICES AND RELATED METHODS**

(30) Priority: 29.06.2023 US 202318344638
(71) Applicant: INTEL Corporation, Santa Clara, CA 95054 (US)
(72) Inventor: KU, Jeff, Santa Clara, 95054 (US); LIM, Min Suet, Santa Clara, 95054 (US); LIN, Lance, Santa Clara, 95054 (US); SEN, Arnab, Santa Clara, 95054 (US); WU, Jiacheng, Santa Clara, 95054 (US)
(74) Representative: Rummler, Felix

(57) **Abstract**

Thermal management systems for electronic devices and related methods are disclosed. An example electronic device includes a chassis including a first cover and a second cover, the first cover including an upper surface and a plurality of side walls and the second cover including a lower surface of the chassis, the first cover and the second cover defining an internal cavity of the chassis, the first cover including a first device inlet formed in a first side wall of the first cover; a fan positioned in the internal cavity, the fan including a first fan inlet and a second fan inlet opposite the first fan inlet; and a side channel positioned between the first device inlet and the first fan inlet to direct fluid flow between the first device inlet and the first fan inlet.

## Description

### FIELD OF THE DISCLOSURE

This disclosure relates generally to hardware and, more particularly, to thermal management systems for electronic devices and related methods.

### BACKGROUND

Electronic devices require thermal systems to manage thermal conditions for maintaining optimal efficiency. To manage thermal conditions, electronic devices employ thermal cooling systems that cool electronic components of the electronic devices during use.

### BRIEF DESCRIPTION OF THE DRAWINGS

FIG. 1 is an example electronic device having an example thermal management system in accordance with teachings of this disclosure.
FIG. 2 is a cross-sectional view of an example base panel of the example electronic device of FIG. 1.
FIG. 3 is a partial bottom view of the example electronic device of FIGS. 1-2.
FIG. 4A is a perspective view of an example fan disclosed herein.
FIG. 4B is a top view of the example fan of FIG. 4A.
FIG. 4C is a bottom view of the example fan of FIG. 4A.
FIG. 5 is a partial perspective view of the electronic device of FIGS. 1-3.
FIG. 6 is a partial perspective view of the example electronic device of FIGS. 1-3 with the example thermal management system superimposed with the example base panel.
FIG. 7 is another partial perspective view of the electronic device of FIGS. 1-3 and 5-6.
FIG. 8 is a partial exploded view of the example thermal management system of FIGS. 1-7.
FIG. 9A are partial perspective, top view of the example thermal management system disclosed herein.
FIG. 9B is a partial perspective bottom view of the example electron device showing the thermal management system superimposed with the example base panel.

The figures are not necessarily to scale. In general, the same reference numbers will be used throughout the drawing(s) and accompanying written description to refer to the same or like parts. As used in this patent, stating that any part (e.g., a layer, film, area, region, or plate) is in any way on (e.g., positioned on, located on, disposed on, or formed on, etc.) another part, indicates that the referenced part is either in contact with the other part, or that the referenced part is above the other part with one or more intermediate part(s) located therebetween.

As used herein, connection references (e.g., attached, coupled, connected, and joined) may include intermediate members between the elements referenced by the connection reference and/or relative movement between those elements unless otherwise indicated. As such, connection references do not necessarily infer that two elements are directly connected and/or in fixed relation to each other. As used herein, stating that any part is in "contact" with another part is defined to mean that there is no intermediate part between the two parts.

Unless specifically stated otherwise, descriptors such as "first," "second," "third," etc., are used herein without imputing or otherwise indicating any meaning of priority, physical order, arrangement in a list, and/or ordering in any way, but are merely used as labels and/or arbitrary names to distinguish elements for ease of understanding the disclosed examples. In some examples, the descriptor "first" may be used to refer to an element in the detailed description, while the same element may be referred to in a claim with a different descriptor such as "second" or "third." In such instances, it should be understood that such descriptors are used merely for identifying those elements distinctly within the context of the discussion (e.g., within a claim) in which the elements might, for example, otherwise share a same name.

As used herein, "approximately" and "about" modify their subjects/values to recognize the potential presence of variations that occur in real world applications. For example, "approximately" and "about" may modify dimensions that may not be exact due to manufacturing tolerances and/or other real world imperfections as will be understood by persons of ordinary skill in the art. For example, "approximately" and "about" may indicate such dimensions may be within a tolerance range of +/- 10% unless otherwise specified in the below description.

As used herein, the term "substantially perpendicular" encompasses the term perpendicular and more broadly encompasses a meaning whereby a first component is positioned and/or oriented relative to a second component at an absolute angle of no more than five degrees (5°) from perpendicular. For example, a first surface that is substantially perpendicular relative to a second surface is positioned and/or oriented relative to the first surface at an absolute angle of between 85 degrees and 95 degrees. As used herein, the term "substantially parallel" encompasses the term parallel and more broadly encompasses a meaning whereby a first component is positioned and/or oriented relative to a second component at an absolute angle of no more than five degrees (5°) from parallel. For example, a first surface that is substantially parallel relative to a second surface is positioned and/or oriented relative to the second surface at an absolute angle of between 0 degrees and 5 degrees.

"Including" and "comprising" (and all forms and tenses thereof) are used herein to be open ended terms. Thus, whenever a claim employs any form of "include" or "comprise" (e.g., comprises, includes, comprising, including, having, etc.) as a preamble or within a claim recitation of any kind, it is to be understood that additional elements, terms, etc., may be present without falling outside the scope of the corresponding claim or recitation. As used herein, when the phrase "at least" is used as the transition term in, for example, a preamble of a claim, it is open-ended in the same manner as the term "comprising" and "including" are open ended. The term "and/or" when used, for example, in a form such as A, B, and/or C refers to any combination or subset of A, B, C such as (1) A alone, (2) B alone, (3) C alone, (4) A with B, (5) A with C, (6) B with C, or (7) A with B and with C. As used herein in the context of describing structures, components, items, objects and/or things, the phrase "at least one of A and B" is intended to refer to implementations including any of (1) at least one A, (2) at least one B, or (3) at least one A and at least one B. Similarly, as used herein in the context of describing structures, components, items, objects and/or things, the phrase "at least one of A or B" is intended to refer to implementations including any of (1) at least one A, (2) at least one B, or (3) at least one A and at least one B. As used herein in the context of describing the performance or execution of processes, instructions, actions, activities and/or steps, the phrase "at least one of A and B" is intended to refer to implementations including any of (1) at least one A, (2) at least one B, or (3) at least one A and at least one B. Similarly, as used herein in the context of describing the performance or execution of processes, instructions, actions, activities and/or steps, the phrase "at least one of A or B" is intended to refer to implementations including any of (1) at least one A, (2) at least one B, or (3) at least one A and at least one B.

As used herein, singular references (e.g., "a", "an", "first", "second", etc.) do not exclude a plurality. The term "a" or "an" object, as used herein, refers to one or more of that object. The terms "a" (or "an"), "one or more", and "at least one" are used interchangeably herein. Furthermore, although individually listed, a plurality of means, elements, or actions may be implemented by, e.g., the same entity or object. Additionally, although individual features may be included in different examples or claims, these may possibly be combined, and the inclusion in different examples or claims does not imply that a combination of features is not feasible and/or advantageous.

### DETAILED DESCRIPTION

During operation of an electronic device (e.g., a laptop, a tablet, etc.), hardware components disposed in a body or housing of the device, such as a processor, graphics card, and/or battery, generate heat. Heat generated by the hardware components of the electronic device can cause a temperature of one or more electronic components to exceed operating temperature limits of the electronic components and/or cause a temperature of a skin enclosure to approach and/or exceed a desired maximum allowable temperature. To prevent overheating of the hardware components and/or skin enclosure temperatures from exceeding a desired threshold, electronic devices include thermal management systems to dissipate heat from the electronic devices.

Example thermal management systems can include active cooling systems or passive cooling systems. Passive cooling systems employ natural convection and heat dissipation by utilizing heat spreaders or heat sinks to increase (e.g., maximize) radiation and convection heat transfer. Due to the amount of heat generated by processors when consuming power, passive cooling systems are often employed with processors that do not exceed approximately 10 watts of power. Processors that exceed 10 watts of power often require active cooling systems to effectively cool these processors below desired maximum operating temperatures to prevent the risk of damage to important internal components from overheating.

Active cooling systems employ forced convention methods to increase a rate of fluid flow, which increases a rate of heat removal. For example, to exhaust heat or hot air generated within the body of the electronic device and cool the electronic device, active cooling systems often employ external devices such as fans or blowers, forced liquid, thermoelectric coolers, etc.. Thus, for certain electronic devices (e.g., laptops, tablets, mobile devices, etc.), a fan can provide a thermal solution to safeguard system performance to a target thermal design power. While examples discussed below describe a fan system, disclosed examples are not limited thereto. Instead, teachings disclosed herein may be implemented in any type of active cooling system.

Generally, an electronic device includes a base panel and a top panel. The base panel houses electronic components including, for example, a circuit board (e.g., a mother board, a daughter board, etc.), a processor, random access memory (RAM), a hard drive, cooling fan, battery, and/or other components of an electronic device. The top panel typically supports a screen or display. The base panel includes an upper surface, side walls or edges (e.g., side or lateral surfaces), and a lower surface (e.g., where all the walls collectively provide a housing or a chassis). In some examples, the chassis includes a first cover (e.g., a C cover) defining the upper surface and a plurality of side walls, and a second cover (e.g., a D cover) defining a lower or bottom surface. In some examples, the chassis includes an upper cover defining an upper surface and a lower cover defining a lower surface and the side surfaces.

The second cover often includes a first (e.g., primary) device inlet(s) through which a fan(s) positioned in the base panel can draw or enable fluid (e.g., air) flow from a surrounding environment. For example, the primary inlet often includes a plurality of openings (e.g., through holes) provided through a bottom surface of the second cover and in fluid communication with a fan first inlet of a fan. During operation, the fan(s) draws air through the first fan inlet via the first device inlet, and causes airflow to circulate around one or more electronic components (e.g., a processor) housed in the electronic device. Further, the fan causes heated air from within the base panel to exit the base panel of the electronic device through a device outlet(s). For example, a device outlet includes one or more openings (e.g. through holes) formed in the side walls of the base panel or can be fluidly coupled to a heat transfer device (e.g., heat sink, heat exchanger, etc.).

In some instances, the first device inlet can become occluded (e.g., blocked, etc.). To prevent air intake issues when the first device inlet is occluded (e.g., positioned on a blocking surface, such as user's lap, etc.), the fan typically includes a secondary fan inlet that can draw air or enable airflow from another area. In an evacuative system, for example, the fan can use the secondary fan inlet to draw air or enable airflow from a core area (e.g., an area housing a processor) of the electronic device. However, this can cause recirculation of heated air due to heat generated by components housed in the electronic device.

Some traditional electronic devices include an alternative flowpath from the first cover (e.g., a C-cover) to a secondary fan inlet positioned adjacent the first cover. For example, the first cover can be implemented with a plurality of through holes on a forehead area of an upper surface of a cover (e.g., a surface above a keyboard of a C cover) to allow air to enter the base panel and, thus, the secondary fan inlet. However, some of the systems require spill proof features, which requires elimination of the through holes from the upper surface (e.g., the forehead area) of the first cover. Further, providing through holes on the forehead area of the first cover increases a fan noise level (e.g., an increase of approximately 1 decibel (dB)) due to noise leakage from the through holes. Moreover, some systems employ smaller form factors that reduce an area for supporting such secondary inlet through holes. For example, some systems employ narrow "forehead" designs and, thus, employing through holes on (e.g., the forehead area of) the first cover is not practical.

Some electronic devices include an alternative path from the first cover to the secondary fan inlet via a breathable keyboard, which allows airflow to penetrate the keyboard and enter the fan through the secondary fan inlet. However, such breathable keyboards do not provide a feasible solution for many electronic devices that require spill proof keyboards.

Examples systems, methods, articles of manufacture, and apparatus disclosed herein enable manufacture of an example thermal management system (e.g., an active cooling system) having multipath airflow inlets. Examples disclosed herein employ an example multi-path ducting and vent system for enabling airflow for a fan. Example electronic devices disclosed herein include a first cover (e.g., a C cover) and a second cover (e.g., a D cover). Examples disclosed herein enable elimination of airflow inlets from an upper surface (e.g., a forehead area) of the first cover (e.g., a C cover) of an electronic device.

Disclosed examples include a first or primary flowpath to channel or enable airflow between a first or primary inlet and a primary fan inlet of a fan, and a secondary or alternative air intake path(s) to channel or enable airflow between a secondary inlet and a secondary fan inlet of the fan. For example, the alternative air intake path(s) can be used to channel or enable airflow to the secondary fan inlet during occlusion of the primary fan inlet (e.g., when the primary inlet of the second cover is occluded).

Certain examples of an alternative air intake path include an example second flowpath (e.g., first alternative intake path) formed between the second cover and the secondary fan inlet. Disclosed examples of the second flowpath include an example fan intake duct (e.g., a bypass duct). In some examples, the fan intake duct is coupled to a fan housing and fluidly couples the secondary fan inlet and an example second inlet (e.g., a second opening) formed in the second cover (e.g., a bottom surface of the D cover) of the electronic device. In some examples, the fan intake duct can couple to a wall or outer surface of a fan housing such that the duct extends from a fan housing to provide a channel to the secondary fan inlet. In some examples, the fan housing and the fan intake duct can be integrally formed as a unitary or one-piece structure.

Certain examples of an alternative air intake path include an example third flowpath (e.g., second alternative intake path) between the first cover and the secondary fan inlet. Disclosed examples of the third flowpath include an example side duct. Example side ducts disclosed herein fluidly couple the secondary fan inlet and a third inlet (e.g., a side inlet or opening) formed in the first cover of the electronic device. In particular, the side intake duct extends between the third inlet of the electronic device and the secondary fan inlet. In some examples, the side duct is supported by or formed with a keyboard support bracket. In some such examples, the side duct includes a first surface (e.g., a lower surface) corresponding to a keyboard support surface, and a second surface (e.g., an upper surface opposite the lower surface) corresponding to a fan housing surface. The third inlet can be formed in a side or vertical wall of the chassis and can be employed to draw or enable airflow to the side duct, which channels airflow to the secondary fan inlet.

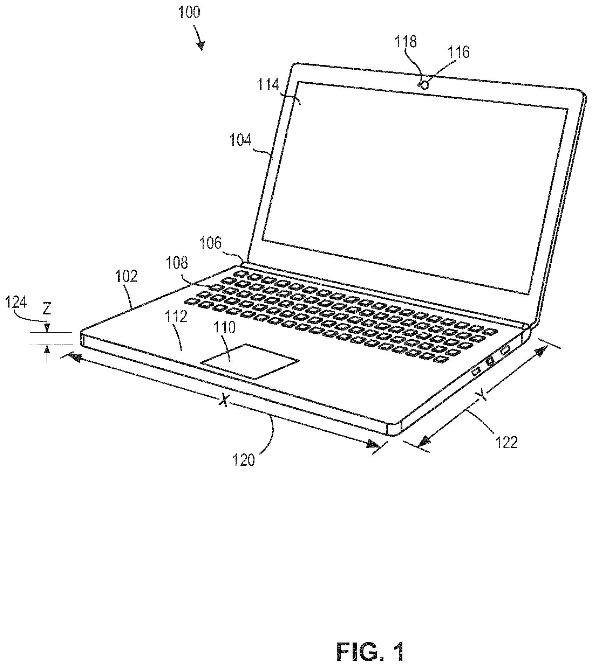

In some electronic devices such as (but not limited to) laptops, a thickness (e.g., z-direction of FIG. 1) is a challenging design factor. Thin laptops are often a desirable consumer product. However, fan modules are often the thickest component housed in a base panel of an electronic device. Example apparatus disclosed herein provide active cooling systems that maintain or reduce space requirements while improving thermal management performance. Specifically, the example active cooling systems disclosed herein preserve space while improving thermal efficiency and/or reducing skin temperature during use.

Certain examples disclosed herein can be integrated and/or retrofit with current electronic devices (e.g., in the field) without removing and/or changing their current components (e.g., maintain their current ducting and mainboard design). In particular, examples disclosed herein enable multiple ducting routes for a secondary inlet of a fan without changing characteristics of an electronic device (e.g., a thickness in the z-direction, part cost, ducting design, etc.). Examples disclosed herein improve cooling capability and reduce fan noise compared to known ducting system with minimal impacts on ducting design and cost. Examples disclosed herein are not limited to hyperbaric systems. Instead, teachings disclosed herein may be implemented in any type of cooling system, such as, for example, an evacuative system.

FIG. 1 is an example electronic device 100 constructed in accordance with teachings of this disclosure. The electronic device 100 of the illustrated example is a mobile device (e.g., a rugged laptop, a laptop, etc.). The electronic device 100 of the illustrated example includes a first or base panel 102 (e.g., housing, lid, etc.) coupled to a second or upper panel 104 (e.g., housing, lid, etc.) via a hinge 106. The hinge 106 enables the upper panel 104 to rotate or fold relative to the base panel 102 between a stored position (e.g., where the upper panel 104 is aligned or parallel with the base panel 102) and an open position as shown in FIG. 1 (e.g., where the upper panel 104 is non-parallel relative to the base panel 102). In the open position, the upper panel 104 can rotate relative to the base panel 102 about the hinge 106 to a desired viewing angle.

To enable user inputs, the base panel 102 of FIG. 1 includes a keyboard 108 and a trackpad 110. For example, the keyboard 108 and the trackpad 110 are exposed at an upper surface 112 (e.g., upper wall) of the base panel 102 (e.g., opposite a bottom surface). The upper panel 104 of the illustrated example carries a display 114, a camera 116 and a microphone 118. The base panel 102 of FIG. 1 forms a chassis that houses or contains electronic components of the electronic device 100. The base panel 102 has a width 120 in a x-direction, a height 122 in a y-direction, and a depth 124 in a z-direction. As used herein, x-direction refers to a direction along the width 120 of the electronic device 100 (e.g., a direction between lateral or side edges), y-direction refers to a direction along a height of the electronic device 100 (e.g., a direction between a front edge and a rear edge of an electronic device), and z-direction refers to a direction along a depth of the electronic device 100 (e.g., between a lower surface and an upper surface of a housing of the electronic device 100). References to the x-y-z direction throughout this specification pertain a direction along the width 120, the height 122, and the depth 124, respectively. The z-direction is in a vertical orientation in FIG. 1.

Although the example electronic device 100 of the illustrated example is a laptop, in some examples, the electronic device 100 can be a tablet, a desktop, a personal computing (PC) device, a mobile device, a cell phone, a smart phone, a hybrid or convertible PC, a server, a modular computing device, a digital picture frame, a graphic calculator, a smart watch, and/or any other electronic device that employs active cooling.

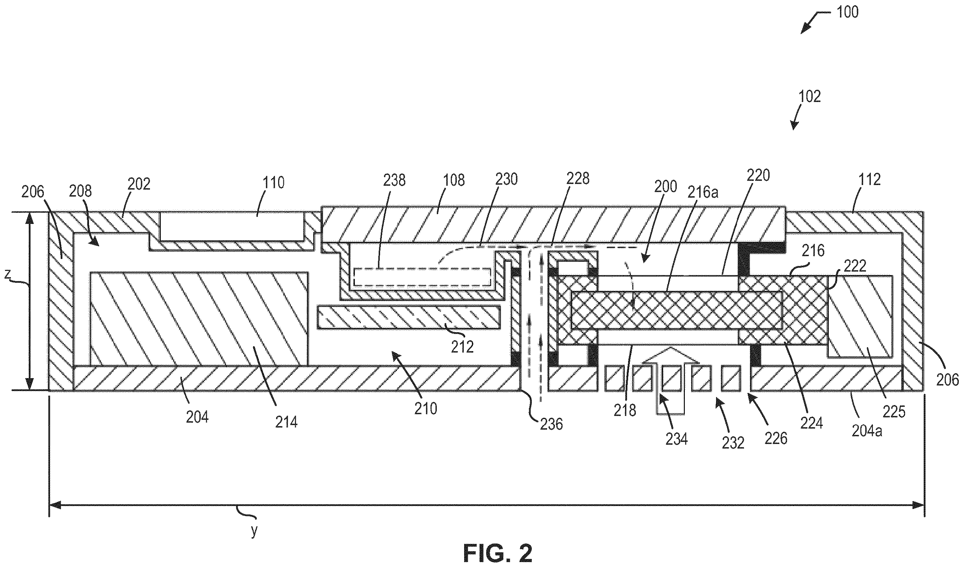

FIG. 2 is a cross-sectional schematic illustration of the base panel 102 of the electronic device 100 of FIG. 1, including an example thermal management system 200 disclosed herein. Specifically, the cross-sectional view is taken along a z-y plane. The base panel 102 (e.g., a chassis) includes an example first (e.g., upper or top) cover 202 and an example second (e.g., lower or base) cover 204. In some examples, the first cover 202 is a C cover, and the second cover 204 is a D cover. The first cover 202 includes the upper surface 112, which exposes the keyboard 108 and the trackpad 110. The first cover 202 also includes example side walls or surfaces 206 extending from the upper surface 112 and toward the second cover 204. The side walls 206 of the illustrated example are in a vertical orientation. While two side walls 206 are illustrated in FIG. 2, the first cover 202 of this example includes four side walls 206. In some examples, the second cover 204 can include a bottom surface 204a and the side walls and the first cover 202 can include the upper surface 112. In some examples, the first cover 202 and the second cover 204 can include one or more side walls that define the chassis.

The base panel 102 defines an internal cavity or chamber 208 between the first and second covers 202, 204 (e.g., having a depth extending in the z-direction of FIG. 1) that houses one or more electronic components 210 of the electronic device 100. While the electronic components 210 of FIG. 2 include an example circuit board 212 (e.g., a stack up), an example battery 214, and an example fan 216, etc., the electronic components 210 can include other components (e.g., circuit board(s), processor(s), memory, etc.) that are not shown.

The thermal management system 200 of the illustrated example includes the fan 216. The fan 216 (e.g., a blower) of the electronic device 100 is positioned in the internal cavity 208 between the first cover 202 and the second cover 204. In other examples, the electronic device 100 can include more than one fan (e.g., two fans, three fans, four fans, etc.). The fan 216 of the illustrated example includes an example first (e.g., primary) fan inlet 218, an example second (e.g., secondary) fan inlet 220 and an example fan outlet 222. While the secondary fan inlet 220 of the illustrated example is substantially parallel to the first fan inlet 218, examples disclosed herein are not limited thereto. For example, the secondary fan inlet 220 can be perpendicular or at an angle (e.g., 45 degrees, etc.) relative to the first fan inlet 218 in other examples.

The fan 216 of the illustrated example is a hyperbaric fan. The fan 216 of the illustrated example includes an example fan housing 224 that covers or houses a motor (not illustrated) and a fan blade 216a that draws airflow from the primary fan inlet 218 and/or the secondary fan inlet 220 and discharges the drawn airflow to the fan outlet 222. The fan outlet 222 of the illustrated example is fluidly coupled to a heat exchanger 225 through which heated airflow from the fan outlet 222 can be channeled or expelled from the cavity 208. In some examples, the fan outlet 222 is fluidly coupled to discharge apertures formed in the base panel 102. In some examples, the fan outlet 222 is adjacent one or more thermal energy management solutions to dissipate heat generated by various computing components (e.g., heat sinks, heat spreaders, cold plates, heat pipes, etc.). Although the electronic device 100 of the illustrated example includes the fan 216, in some examples, the electronic device 100 can include another other type of circulation device(s) that facilitates active cooling such as, but not limited to, a blower, a pump, etc.

The thermal management system 200 of the illustrated example provides multiple fluid flow passageways or pathways to remove heat from within the base panel 102. For example, the fan 216 intakes cool air (e.g., ambient air) from the environment outside of the internal cavity 208 and creates air pressure inside the fan housing 224 to cause or move heated air out of the cavity 208 and/or away from a processor or other electronic components. The thermal management system 200 of the illustrated example includes an example first flowpath 226 (e.g., a first fluid flow passageway or channel), an example second flowpath 228 (e.g., a second fluid flow passageway or channel) and an example third flowpath 230 (e.g., a second fluid flow passageway or channel). The first flowpath 226 provides or enables airflow to the first fan inlet 218. The second flowpath 228 and/or the third flow path 230 can provide or enable airflow to the secondary fan inlet 220. Thus, the second flowpath 228 and/or the third flow path 230 of the illustrated example are alternative flow paths. Although two alternative flowpaths are shown in the illustrated example, the thermal management system 200 can include one or more than two additional/alternative flowpaths in other examples. The thermal management system 200 of the illustrated example enables elimination of vent and/or air intake openings on the upper surface 112 of the first cover 202. Thus, the C cover can be formed without inlet and/or vent openings in the upper surface or forehead area of the C cover.

To provide the first flowpath 226, the base panel 102 of the illustrated example includes an example first device inlet 232 (e.g., a primary device inlet) in fluid communication with the first fan inlet 218. In the illustrated example, the first fan inlet 218 is fluidly coupled or positioned adjacent the first device inlet 232. The chassis (e.g., the second cover 204) defines the first flowpath 226. The first flowpath 226 is fluidly isolated from the second flowpath 228 and/or the third flowpath 230. The first device inlet 232 of the illustrated example is provided by one or more first apertures 234 formed in the second cover 204. In the illustrated example, the first apertures 234 are through holes formed in a bottom surface 204a of the second cover 204. The first flowpath 226 provides or enables airflow from an ambient environment surrounding the electronic device 100, through the first apertures 234 of the first device inlet 232, and to the first fan inlet 218. For example, during operation of the electronic device 100, the fan 216 can draw fluid (e.g., air, a liquid, etc.) through the first flowpath 226 provided by the first fan inlet 218 and the first device inlet 232.

To provide the second flowpath 228, the base panel 102 of the illustrated example includes a second device inlet 236. The second device inlet 236 of the illustrated example is formed in the second cover 204. The second device inlet 236 is separate or spaced from the first device inlet 232. In the illustrated example, the second device inlet 236 includes one or more openings or apertures formed in the second cover 204. To provide the third flowpath 230, the base panel 102 of the illustrated example includes a third device inlet 238. The third device inlet 238 of the illustrated example is formed in the first cover 202. Specifically, the third device inlet 238 is formed in a side wall 206 (e.g., a vertical side wall) of the first cover 202 along the y-direction.

The second and third flowpaths 228, 230 provide alternative flowpaths that enable the fan 216 to draw or intake fluid (e.g., cool air) from the environment. In some instances, for example, the first device inlet 232 can be occluded during operation of the electronic device 100. For example, the electronic device 100 may be positioned on a surface (e.g., a lap, a desk, a pillow, etc.) that prevents or restricts fluid flow to the first fan inlet 218. In some such instances, the thermal management system 200 disclosed herein provides a multi-path ducting and/or vent system via the flowpaths 230 and/or 232 to prevent or reduce fluid intake restrictions when airflow to the first fan inlet 218 is occluded. Further, the second and third flowpaths 228, 230 are structured to support and/or protect the electronic components 210 housed in the electronic device 100.

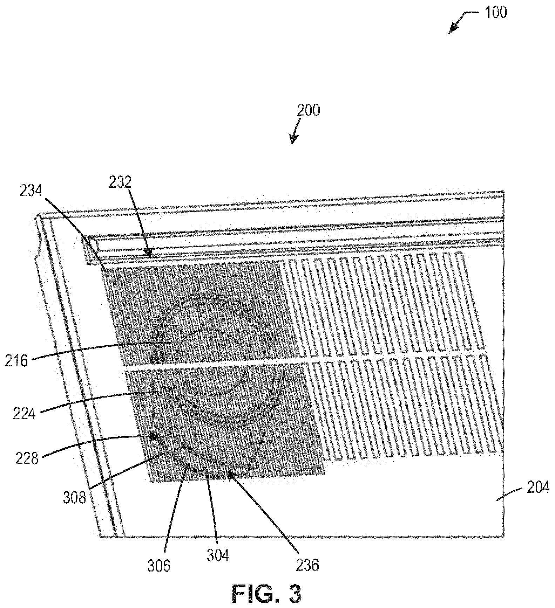

FIG. 3 is a partial bottom view of the example electronic device 100 of FIGS. 1-2. FIG. 3 shows the second flowpath 228 of the thermal management system 200 of FIG. 2. As illustrated in FIG. 3, the second cover 204 includes the example second device inlet 236 defined by one or more second apertures 304 in the second cover 204. The fan 216 of the illustrated example includes an example on-fan duct 306 (e.g., a side duct, a conduit, etc.) coupled to or extending from the fan 216. The second device inlet 236 is positioned (e.g., extends) over the on-fan duct 306. In other words, the second device inlet 236 is aligned (e.g., axially aligned) with a passageway of the on-fan duct 306 so that airflow from the second device inlet 236 flows through the on-fan duct 306. The on-fan duct 306 of the illustrated example is an example wall or duct 308 that extends from the fan housing 224. The wall 308 provides a fluid flow passageway to fluidly couple the second device inlet 236 and the secondary fan inlet 220 (FIG. 2). In some examples, the second device inlet 236 is the same as the first device inlet 232 (e.g., the first apertures 234 of the first device inlet 232 extend over the second apertures 304). For example, the second cover 204 can include an enlarged first device inlet 232 (e.g., first apertures 234 elongated by several millimeters) to port the on-fan duct 306.

During operation, the fan 216 utilizes the on-fan duct 306 that protrudes from the fan housing 224 to provide or enable the second flowpath 228 for guiding airflow from the second cover 204 to the secondary fan inlet 220. Thus, the on-fan duct 306 enables airflow from the second cover 204 to bypass the first fan inlet 218 and direct the airflow towards the secondary fan inlet 220. In particular, the second flowpath 228 extends from the second device inlet 236 of the second cover 204 and the secondary fan inlet 220 and the on-fan duct 306 is interposed in the second flowpath 228.

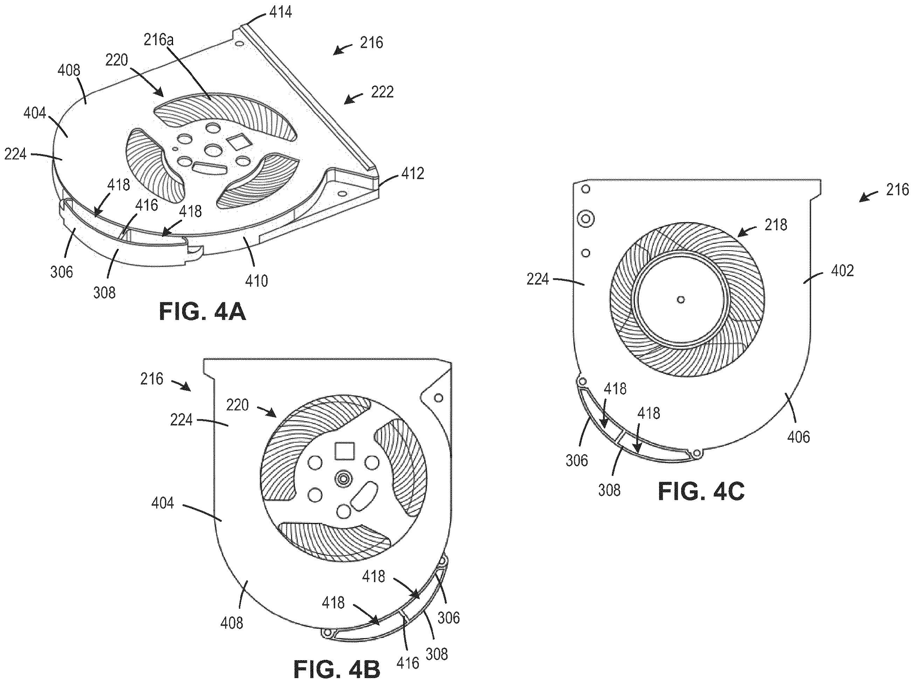

FIG. 4A is a perspective view of the example fan 216 of FIGS. 1-3. FIG. 4B is a top view of the example fan 216 of FIGS. 1-3. FIG. 4C is a bottom view of the example fan 216 of FIGS. 1-3. Referring to FIGS. 4A-4C, the fan 216 of the illustrated example has a first (e.g., bottom) side 402 and a second (e.g., top) side 404 opposite the first side. The fan housing 224 includes an example first housing cover 406 (FIG. 4C) corresponding to the first side 402 of the fan 216, an example second cover 408 (FIG. 4B) corresponding to the second side 404 of the fan 216, and an example side cover 410 (FIG. 4A) positioned between the first and second covers 406, 408. The first cover 406 is substantially parallel to the second 408, and the side cover 410 is substantially perpendicular relative to the first and second covers 406, 408. The first cover 406 of the fan housing 224 includes or defines the first fan inlet 218 and the second cover 408 of the fan housing 224 includes or defines the secondary fan inlet 220.

Referring to FIG. 4A, the side cover 410 extends from a first side 412 of the fan outlet 222, around example fan blades 216a of the fan 216, and to a second side 414 of the fan outlet 222. The wall 308 of the on-fan duct 306 is coupled to and extends from the side cover 410 of the fan housing 224. In other words, the wall 308 and a portion of the side cover 410 form the on-fan duct 306 to guide fluid flow from the second device inlet 236 (FIG. 2) to the secondary fan inlet 220. The on-fan duct 306 (e.g., the wall 308) of the illustrated example has a shape or profile (e.g., a radius of curvature) that is substantially similar or identical to a shape or profile (e.g., a radius of curvature) of the side cover 410. The on-fan duct 306 of the illustrated example extends across a portion of a circumference of the side cover 410. Thus, the wall 308 has a curved profile that extends along a portion of an outer peripheral edge of the fan housing 224 defined by the side cover 410. The support wall 308 of the on-fan duct 306 of the illustrated example includes a rib 416 extending between the wall 308 and the side cover 410. The on-fan duct 306 defines a plurality of airflow channels 418 to allow airflow to flow from the second device inlet 236 to the second fan inlet 236. The airflow channels 418 allow fluid flow through the on-fan duct 306 in a direction from the second cover 204 toward the first cover 202. Thus, a first side of the on-fan duct 306 oriented toward the second cover 204 defines a fan duct inlet and a second side of the on-fan duct 306 oriented toward the first cover 202 defines a fan duct outlet of the airflow channels 418. In the orientation of FIGS. 4A-4C, the channels 418 are vertically oriented. However, in other examples, the channels 418 can be oriented at an angle relative to vertical.

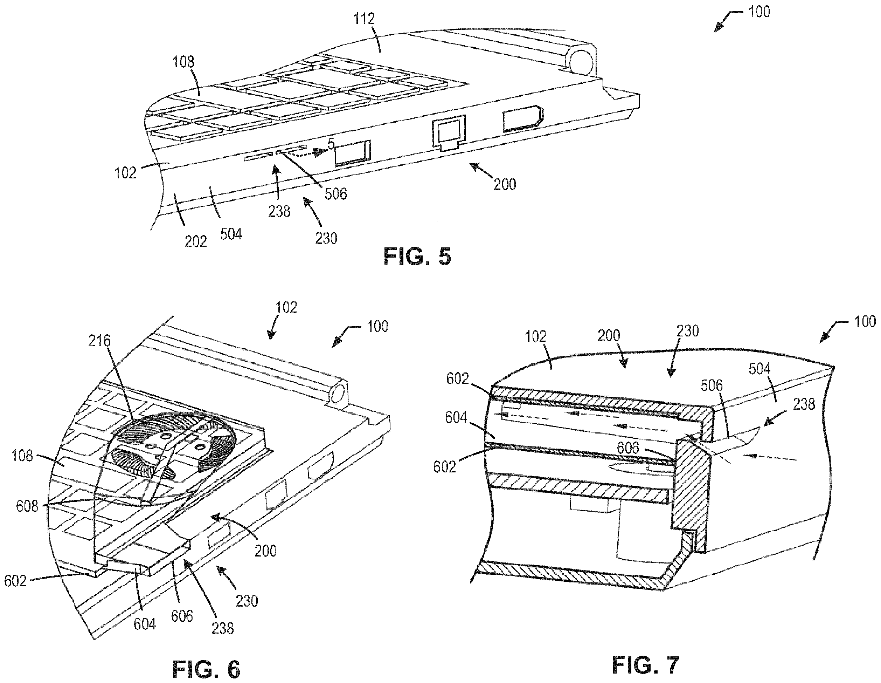

FIGS. 5-7 are partial perspective views of the example electronic device 100 of FIGS. 1-3, showing the third flowpath 230 of the thermal management system 200 of FIG. 2. FIG. 5 is a partial perspective side view of the example electronic device 100 of FIGS. 1-3 illustrating the example third device inlet 238. FIG. 5 illustrates the upper surface 112 and the keyboard 108 of the electronic device 100 of FIGS. 1-3. In the illustrated example of FIG. 5, the first cover 202 includes the upper surface 112 of the base panel 102 and an example first side surface 504 (e.g., first lateral side, a side vertical wall) that extends (e.g., downwardly) from the upper surface 112. The first side surface 504 of the illustrated example is a right-side wall of the first cover 202. The first side surface 504 is perpendicular or oriented orthogonal relative to a rear surface of the first cover 202. For example, the upper surface 112, the first side surface 504, and/or another side surfaces of the base panel 102 can be integrally formed as a unitary piece or otherwise coupled with one another. In this example, the third device inlet 238 is provided by one or more apertures 506 in the first side surface 504 of the first cover 202. In other examples, the third device inlet 238 can be formed on a front surface of the first cover 202, a left-side surface of the first cover 202, and/or a rear surface of the first cover 202. While the third device inlet 238 of FIG. 5 includes two apertures 506, the third device inlet 238 may include one aperture 506 or more than two apertures 506 (e.g., 3, 4, etc.) in other examples. The third device inlet 238 provides a third fluid inlet for the fan 216 to draw or enable air (e.g., ambient air) from the environment.

FIG. 6 is a partial perspective view of FIG. 5 showing the third flow path 230 superimposed on the electronic device 100. The keyboard 108 of the electronic device 100 of the illustrated example. In this example, the keyboard 108 includes a keyboard support bracket 602 (e.g., keyboard bracket) structured to support the keyboard 108 and retain or secure the fan 216. The bracket 602 of FIG. 6 is also part of the thermal management system 200 disclosed herein. Referring to FIG. 6, the bracket 602 includes an example bracket or side duct 604 (e.g., a channel, a tube, a pipe, etc.) to form a flow channel or fluid passageway between the bracket 602 and the keyboard 108 to guide airflow from the third device inlet 238 to the secondary fan inlet 220. The side duct 604 of the illustrated example extends between an example side duct inlet 606 (e.g., an upstream end of the side duct 604) and an example side duct outlet 608 (e.g., a downstream end of the side duct 604). The side duct outlet 608 of the illustrated example is fluidly coupled to or in fluid communication with the fan 216. The fan 216 utilizes the side duct 604 to enable the third flowpath 230 of the thermal management system 200. For example, the side duct 604 is interposed in the third flowpath 230 between the third device inlet 238 and the second fan inlet 236. In the illustrated example, the side duct 604 defines a fluid flow passageway that is substantially horizontal in the orientation of FIG. 6. Thus, the bracket 602 facilitates or supports the side duct 604 of the third flowpath 230. The third flowpath 230 of the illustrated example extends from the third device inlet 238 that draws fluid from an environment surrounding the electronic device 100, through the side duct 604 via the side duct inlet 606, and to the secondary fan inlet 220 of the fan 216. The side duct inlet 606 and/or the openings 506 of the illustrated example is substantially or exactly flush mounted relative to an outer surface of the side surface 504. However, in some examples, the side duct inlet 606 can be recessed within the internal cavity 208 (FIG. 2) relative to the first side surface 504 and/or can protrude from the first side surface 504.

FIG. 7 is a perspective, cross-sectional view of the example third flowpath 230 taken along line 5-5 of FIG. 5. As illustrated in FIG. 7, the third device inlet 238 is in fluid communication with the side duct 604 via the side duct inlet 606. In some examples, the bracket 602 is made of stamped sheet metal and the ducting features could be made directly on the sheet metal part without adding cost. However, in other examples, the bracket 602 can be made of a first material (e.g., sheet metal, plastic, etc.) and the side duct 604 can be made of a second material (e.g., sheet metal, plastic, etc.) that is the same or different than the first material. The bracket 602 of FIG. 7 is formed of sheet metal. However, the bracket 602 can be formed of additional or alternative materials in other examples.

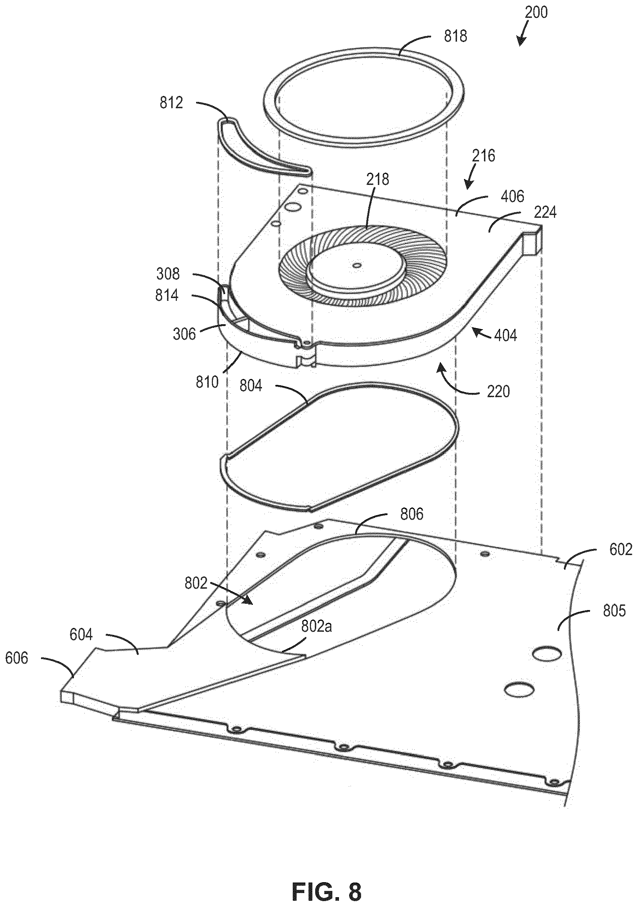

FIG. 8 is a partial exploded view of the example thermal management system 200 disclosed herein. The thermal management system 200 of the illustrated example includes the fan 216 of FIGS. 2-7 and the bracket 602 of FIGS. 6-7. As illustrated in FIG. 8, the bracket 602 includes an example cavity 802 (e.g., opening, etc.) to retain the fan 216 with the on-fan duct 306. The bracket 602 of the illustrated example includes a cut-out or cut-away portion 802a to receive (e.g., matably receive) the on-fan duct 306.

The thermal management system 200 of the illustrated example further includes an example first gasket 804 to provide a first seal between the secondary fan inlet 220 and the second and third device inlets 236, 238 (FIG. 2). The first gasket 804 is to be positioned between a first surface 805 of the bracket 602 and the fan 216. Additionally, the first gasket 804 is positioned between the first surface 805 and the on-fan duct 306. In particular, the first gasket 804 is to be positioned on the first surface 805 around or adjacent a first perimeter 806 of the cavity 802. Thus, the first gasket 804 of the illustrated example has a shape complementary to the shape of the cavity 802. Thus, the first gasket 804 engages the second side 404 of the fan 216 and a first wall edge 810 of the on-fan duct 306. The first gasket 804 prevents or restricts airflow exiting the side duct outlet 608 of the side duct 604 from leaking or escaping laterally (e.g., horizontally) between the bracket 602 and the fan housing 224.

The thermal management system 200 of the illustrated example further includes an example second gasket 812. The second gasket 812 of the illustrated example provides a second seal between the secondary fan inlet 220 and the second device inlet 236 (FIG. 2). The second gasket 812 is positioned between the second cover 204 of the base panel 102 (FIG. 2) and the first cover 406 of the fan 216. In particular, the second gasket 812 seals about a third perimeter corresponding to the on-fan duct 306. The third perimeter of the on-fan duct 306 of the illustrated example has a quarter-moon or arcuate shape. However, in some examples, the perimeter can have any other shape. The second gasket 812 is positioned on a second side 814 of the on-fan duct 306 opposite a first side having the first gasket 804. Thus, the first gasket 804 seals a first side of the on-fan duct 306 and the second gasket 812 seals a second side of the on-fan duct 306 opposite the first side.

The thermal management system 200 of the illustrated example further includes an example third gasket 818 to provide a third seal between the first fan inlet 218 and the first device inlet 232 (FIG. 2). The third gasket 818 is to be positioned between the second cover 204 of the base panel 102 (FIG. 2) and the first cover 406 of the fan 216. In particular, the third gasket 818 is to seal a fourth perimeter corresponding to the first fan inlet 218. The third gasket 818 and/or the fourth perimeter of the illustrated example is a circular shape (e.g., a ring shape). The first gasket 804, the second gasket 812 and/or the third gasket 818 can be O-rings and/or seals composed of rubber, plastic, and/or any other material(s).

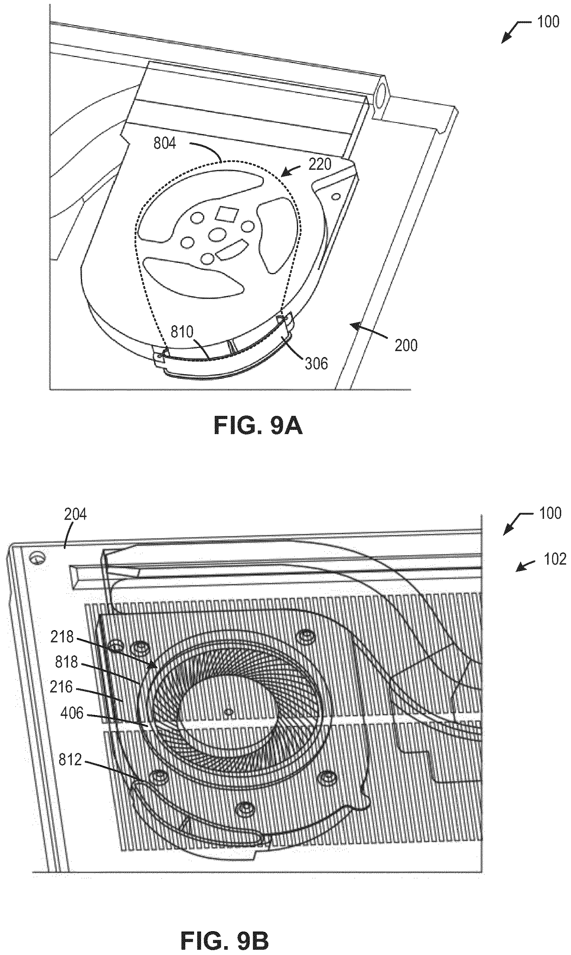

FIGS. 9A and 9B are partial perspective views of the example electronic device 100 of FIGS. 1-7. FIG. 9A is a top view of the electronic device 100 with the bracket 602 and first cover 202 removed to expose a portion of the example thermal management system 200 disclosed herein. As illustrated in FIG. 9A, the first gasket 804 is positioned around the second perimeter corresponding to the combination the first wall edge 810 of the on-fan duct 306 and the secondary fan inlet 220.

FIG. 9B is a bottom view of the electronic device 100 showing another portion of the example thermal management system 200 disclosed herein. As illustrated in FIG. 9B, the second gasket 812 is positioned between the second cover 204 of the base panel 102 and the first cover 406 of the fan 216 to provide a seal (e.g., a tight fluid seal) between the secondary fan inlet 220 (FIG. 9A) and the second device inlet 236. FIG. 9B also shows the third gasket 818 positioned between the second cover 204 of the base panel 102 and the first cover 406 of the fan 216 around a perimeter of the first fan inlet 218.

From the foregoing, it will be appreciated that example methods, apparatus, systems, and articles of manufacture to provide integrated duct systems for electronic devices are disclosed herein. Examples disclosed herein include integrated ducting system(s) to channel airflow to a first (e.g., primary) fan inlet and a second (e.g., secondary) fan inlet.

Certain examples disclosed herein can be integrated and/or retrofit with current electronic devices (e.g., in the field) without removing and/or changing (e.g., physically altering) their current components (e.g., maintain their current ducting and mainboard design). In particular, examples disclosed herein enable multiple ducting passages for a secondary inlet of a fan without changing a height (e.g., in the z-direction), part cost, and/or ducting design. Examples disclosed herein improve cooling capability and/or lower fan noise compared to known ducting systems with minimal impacts on ducting design and cost. Examples disclosed herein can be implemented in both evacuative and/or hyperbaric systems. Examples disclosed herein enable manufacture of flowpaths to a secondary fan inlet that eliminate a need for forehead inlet holes typically located on an upper surface of a C cover.

Example multi-path duct systems and associated methods are disclosed herein. Further examples and combinations thereof include the following:
Example 1 includes an electronic device comprising a chassis including a first cover and a second cover, the first cover including an upper surface and a plurality of side walls and the second cover including a lower surface of the chassis, the first cover and the second cover defining an internal cavity of the chassis, the first cover including a first device inlet formed in a first side wall of the plurality of side walls of the first cover; a fan positioned in the internal cavity, the fan including a first fan inlet and a second fan inlet opposite the first fan inlet; and a side channel positioned between the first device inlet and the first fan inlet to direct fluid flow between the first device inlet and the first fan inlet.
Example 2 includes the electronic device of example 1, wherein the side channel is defined by a side duct fluidly coupled to the first device inlet and to the first fan inlet.
Example 3 includes the electronic device of example 2, wherein the side duct is coupled to a keyboard support bracket, the keyboard support bracket structured to secure the fan.
Example 4 includes the electronic device of example 3, wherein the side duct is integrally formed with a keyboard support bracket, the keyboard support bracket structured to secure the fan.
Example 5 includes the includes the electronic device of any one of examples 3-4, wherein the keyboard support bracket is formed of stamped sheet metal.
Example 6 includes the includes the electronic device of any one of examples 3-5, further including a first gasket positioned between the first fan inlet and the keyboard bracket adjacent a side duct outlet of the side duct.
Example 7 includes the electronic device of example 6, wherein the fan includes a fan housing having a first surface, a second surface substantially parallel to the first surface, and a third surface coupling the first and second surfaces, the third surface to be substantially perpendicular relative to the first and second surface, the third surface to have a first shape.
Example 8 includes the electronic device of example 7, wherein the electronic device further includes an on-fan duct coupled to and extending from the third surface of the fan housing, the on-fact duct to have a second shape that is substantially similar to the first shape of the third surface.
Example 9 includes the electronic device of example 8, wherein the second cover includes a second device inlet to enable fluid flow through the on-fan duct, the second device inlet being substantially perpendicular relative to the first device inlet.
Example 10 includes the electronic device of example 9, further including a second gasket positioned between the first cover and the on-fan duct.
Example 11 includes the electronic device of example 10, wherein the second cover includes a third device inlet spaced from the second device inlet, the third device inlet to enable fluid flow to the second fan inlet of the fan.
Example 12 includes an electronic device comprising a chassis; a fan housed in the chassis, the fan including a first fan inlet and a second fan inlet opposite the first fan inlet; a first fluid passageway provided in the chassis, the first fluid passageway to enable fluid flow between a first device inlet and the first fan inlet, the first device inlet formed in a bottom surface of the chassis; a second fluid passageway provided in the chassis, the second fluid passageway to enable fluid flow between a second device inlet and the second fan inlet, the second device inlet formed in the bottom surface of the chassis and spaced from the first device inlet; and a third fluid passageway provided in the chassis, the third fluid passageway to enable fluid flow between a third device inlet and the second fan inlet, the third device inlet formed in a side wall of the chassis, the side wall positioned between an upper surface of the chassis and the bottom surface of the chassis.
Example 13 includes the electronic device of example 12, wherein the first device inlet includes a plurality of first apertures formed in a D cover of the chassis.
Example 14 includes the electronic device of any ones of examples 12-13, wherein the second device inlet includes a plurality of second apertures formed in a D cover of the chassis.
Example 15 includes the electronic device of any ones of examples 12-14, wherein the third device inlet corresponds to a plurality of third apertures formed in the side wall of a C cover of the chassis.
Example 16 includes the electronic device of any ones of examples 12-15, wherein the second fluid passageway includes an on-fan duct coupled to a fan housing, the on-fan duct including a flow channel to enable fluid flow through the on-fan duct between the second device inlet and the second fan inlet.
Example 17 includes the electronic device of example 16, wherein the third fluid passageway includes a side duct supported on a keyboard support bracket, the side duct having a flow channel to enable fluid flow through the side duct between the third device inlet and the second fan inlet.
Example 18 includes the electronic device of example 12, further including a first gasket positioned between the on-fan duct and the upper surface of the chassis, a second gasket positioned adjacent a side duct outlet and between the keyboard support bracket and a first side of the fan defining the first fan inlet, and a third gasket positioned between the bottom surface of the chassis and the first side of the fan defining the first fan inlet.
Example 19 includes a thermal management system for an electronic device comprising a first cover having an upper wall and a side wall extending from the upper wall, the side wall including a first device inlet; a second cover coupled to the first cover to define a cavity, the second cover including a second device inlet and a third device inlet spaced from the second device inlet; a fan having a first fan inlet and a second fan inlet opposite the first fan inlet, the first fan inlet to be in fluid communication with the third device inlet, the second fan inlet to be in fluid communication with the first device inlet and the second device inlet; a first fluid passageway defined by the second cover to fluidly couple the first fan inlet and the third device inlet; a first duct to fluidly couple the first device inlet and the second fan inlet; and a second duct coupled to the fan, the second duct to fluidly couple the second device inlet and the second fan inlet.
Example 20 includes the system of example 19, wherein the first fluid passageway is fluidly isolated from the first duct and the second duct.

The following claims are hereby incorporated into this Detailed Description by this reference. Although certain example systems, apparatus, articles of manufacture, and methods have been disclosed herein, the scope of coverage of this patent is not limited thereto. On the contrary, this patent covers all systems, apparatus, articles of manufacture, and methods fairly falling within the scope of the claims of this patent.

## Claims

1. An electronic device comprising:
a chassis including a first cover and a second cover, the first cover including an upper surface and a plurality of side walls and the second cover including a lower surface of the chassis, the first cover and the second cover defining an internal cavity of the chassis, the first cover including a first device inlet formed in a first side wall of the plurality of side walls of the first cover;
a fan positioned in the internal cavity, the fan including a first fan inlet and a second fan inlet opposite the first fan inlet; and
a side channel positioned between the first device inlet and the first fan inlet to direct fluid flow between the first device inlet and the first fan inlet.

2. The electronic device of claim 1, wherein the side channel is defined by a side duct fluidly coupled to the first device inlet and to the first fan inlet.

3. The electronic device of claim 2, wherein the side duct is coupled to a keyboard support bracket, the keyboard support bracket structured to secure the fan.

4. The electronic device of claim 3, wherein the side duct is integrally formed with a keyboard support bracket, the keyboard support bracket structured to secure the fan.

5. The electronic device of any one of claims 3-4, wherein the keyboard support bracket is formed of stamped sheet metal.

6. The electronic device of any one of claims 3-5, further including a first gasket positioned between the first fan inlet and the keyboard support bracket adjacent a side duct outlet of the side duct.

7. The electronic device of claim 6, wherein the fan includes a fan housing having a first surface, a second surface substantially parallel to the first surface, and a third surface coupling the first and second surfaces, the third surface to be substantially perpendicular relative to the first and second surface, the third surface to have a first shape.

8. The electronic device of claim 7, wherein the electronic device further includes an on-fan duct coupled to and extending from the third surface of the fan housing, the on-fact duct to have a second shape that is substantially similar to the first shape of the third surface.

9. The electronic device of claim 8, wherein the second cover includes a second device inlet to enable fluid flow through the on-fan duct, the second device inlet being substantially perpendicular relative to the first device inlet.

10. The electronic device of claim 9, wherein the second device inlet includes a plurality of first apertures formed in the second cover of the chassis.

11. The electronic device of claim 9, further including a second gasket positioned between the second cover and the on-fan duct.

12. The electronic device of claim 9, wherein the second cover includes a third device inlet spaced from the second device inlet, the third device inlet to enable fluid flow to the second fan inlet of the fan.

13. The electronic device of claim 12, wherein the third device inlet includes a plurality of second apertures formed in the second cover of the chassis.

14. The electronic device of any one of claims 12-13, wherein a first fluid passageway defined by the side channel is fluidly isolated from a second fluid passageway defined the third device inlet and the second fan inlet.

15. The electronic device of any one of claims 12-14, further including a third gasket positioned between the second cover and the third device inlet.
